# EUROPEAN PATENT APPLICATION

(11) **EP 4 492 584 A1**
(43) Date of publication of application: **15.01.2025**
(21) Application number: 24188405.5
(22) Date of filing: 12.07.2024
(51) Int. Cl.: H01R 13/24, H01R 13/20, H01R 12/72, H01R 13/11, H01R 13/17

(54) **ELECTRICAL CONNECTION ASSEMBLY**

(30) Priority: 14.07.2023 US 202363526750 P
(71) Applicant: Delta Electronics, Inc., Taoyuan City 33370 (TW)
(72) Inventor: Lai, Chien-An, 32063 Taoyuan City (TW); Wang, Yu-Tai, 32063 Taoyuan City (TW); Cheng, Hao-Peng, 32063 Taoyuan City (TW); Chen, I, 32063 Taoyuan City (TW)
(74) Representative: Uexküll & Stolberg

(57) **Abstract**

The present disclosure provides an electrical connection assembly including a first electrical connector (1, 1a) and a second electrical connector (2, 2a). The first electrical connector (1, 1a) includes a first terminal (11). The first terminal (11) includes a contact part (111a). The second electrical connector (2, 2a) is configured to pluggably connect with the first electrical connector (1, 1a), and includes a second terminal (21). The second terminal (21) includes a recess (211). The recess (211) is inwardly recessed from a surface (210) of the second terminal (21) and includes a connection section (213) and a bottom (212). The connection section (213) is in connection between the bottom (212) and the surface (210) of the second terminal (21), and includes a plurality of contact portions (215). The contact part (111a) of the first terminal (11) is in connection with the recess (211) of the second terminal (21), and the contact part (111a) of the first terminal (11) is in contact with the bottom (212) and the contact portions (215) of the recess (211) of the second terminal (21) to form a multi-points contact.

## Description

### FIELD OF THE INVENTION

The present disclosure relates to a connector, and more particularly to an electrical connection assembly.

### BACKGROUND OF THE INVENTION

Nowadays, the power density and efficiency requirements of power supply products are increasing. According to the specifications of the MCRPS (Modular Hardware System-Common Redundant Power Supply) platform, the wattage of power supply unit with 12V output voltage has been increased to 3200W to 3600W. In other words, in applications with high wattage and high current, the losses generated by the contact impedance of electrical connectors cannot be ignored. This not only leads to a decrease in power density and efficiency but may also cause safety issues due to temperature rise.

Traditional electrical connection assembly typically includes a female connector and a male connector. The female connector includes a plurality of terminals arranged symmetrically. The male connector includes contact portions. The male connector is pluggably connected with the female connector and allows the contact portions thereof to clamp and contact the plurality of terminals of the female connector, so as to achieve the electrical connection between the male connector and female connector. However, each terminal of the female connector is in contact with the corresponding contact portion of the male connector by only one point, which results in higher contact impedance. Additionally, the terminals of the female connector are typically made of copper, which has a relatively low tolerance for high temperatures. When the terminals of the female connector are in electrical contact with the contact portions of the male connector in a point-contact manner, the higher contact impedance may lead to temperature rise, which may cause the temperature of the terminals to exceed the material's temperature tolerance and cause safety issues.

On the other hand, some traditional electrical connection assemblies increase the clamping force applied to the terminals of the female connector, so as to increase the contact areas between the contact portions of the male connector and the terminals of the female connector and achieve the advantage of reducing the contact impedance. However, when the clamping force between the terminals of the female connector is increased, the stress on the contact portions of the male connector is increased, which potentially leads to structural damage or material fatigue issues.

Therefore, there is a need of providing an electrical connection assembly to obviate the drawbacks encountered from the prior arts.

### SUMMARY OF THE INVENTION

It is an object of the present disclosure to provide an electrical connection assembly. The electrical connection assembly includes a first electrical connector and a second electrical connector. When the second electrical connector is plugged into the first electrical connector, the contact parts of the first terminals of the first electrical connector are in contact with the corresponding recesses of the second terminals of the second electrical connector, so that the contact areas between the first terminals and the second terminals are increased. Consequently, the contact impedance is reduced to minimize losses, the power density and efficiency are enhanced, the temperature rise issues caused by excessive contact impedance are prevented, and the structural damage or the material fatigue due to high stress are avoided.

In accordance with one aspect of the present disclosure, an electrical connection assembly is provided. The electrical connection assembly includes a first electrical connector and a second electrical connector. The first electrical connector includes at least one first terminal. Each of the at least one first terminal includes at least one contact part. The second electrical connector is configured to pluggably connect with the first electrical connector, and includes at least one second terminal. Each of the at least one second terminal includes at least one recess. The at least one recess is inwardly recessed from a surface of the second terminal. Each of the at least one recess includes at least one connection section and a bottom. The at least one connection section is in connection between the bottom and the surface of the second terminal. The at least one connection section comprises a plurality of contact portions. The at least one contact part of each of the at least one first terminal of the first electrical connector is in connection with and urges against the at least one recess of the corresponding second terminal of the second electrical connector, and the at least one contact part of the at least one first terminal is in contact with and urges against the bottom and the plurality of contact portions of the at least one recess of the at least one second terminal to form a multi-points contact.

### BRIEF DESCRIPTION OF THE DRAWINGS

FIG. 1 is a schematic perspective view illustrating an electrical connection assembly according to a first embodiment of the present disclosure;
FIG. 2 is a cross-sectional view illustrating a first electrical connector and a second electrical connector of the electrical connection assembly of FIG. 1;
FIG. 3 is a cross-sectional view illustrating the second electrical connector of the electrical connection assembly of FIG. 1 in connection with the first electrical connector;
FIG. 4 is a partially enlarged cross-sectional view illustrating the electrical connection assembly in area A of FIG. 3;
FIG. 5 is a cross-sectional view illustrating a first electrical connector and a second electrical connector of an electrical connection assembly according to a second embodiment of the present disclosure;
FIG. 6 is a cross-sectional view illustrating the second electrical connector of the electrical connection assembly of FIG. 5 in connection with the first electrical connector;
FIG. 7 is a cross-sectional view illustrating a first electrical connector and a second electrical connector of an electrical connection assembly according to a third embodiment of the present disclosure;
FIG. 8 is a schematic perspective view illustrating the electrical connection assembly applied to a power supply system;
FIG. 9 is a schematic perspective view illustrating an electrical connection assembly according to a fourth embodiment of the present disclosure;
FIG. 10 is a partial cross-sectional view illustrating a first electrical connector and a second electrical connector of the electrical connection assembly of FIG. 9; and
FIG. 11 is a cross-sectional view illustrating the second electrical connector of the electrical connection assembly of FIG. 10 in connection with the first electrical connector.

### DETAILED DESCRIPTION OF THE PREFERRED EMBODIMENT

The present disclosure will now be described more specifically with reference to the following embodiments. It is to be noted that the following descriptions of preferred embodiments of this disclosure are presented herein for purpose of illustration and description only. It is not intended to be exhaustive or to be limited to the precise form disclosed. For example, the formation of a first feature over or on a second feature in the description that follows may include embodiments in which the first and second features are formed in direct contact, and may also include embodiments in which additional features may be formed between the first and second features, such that the first and second features may not be in direct contact. In addition, the present disclosure may repeat reference numerals and/or letters in the various examples. This repetition is for the purpose of simplicity and clarity and does not in itself dictate a relationship between the various embodiments and/or configurations discussed. Further, spatially relative terms, such as "inner," "outer," "top," "bottom" and the like, may be used herein for ease of description to describe one element or feature's relationship to another element(s) or feature(s) as illustrated in the figures. The spatially relative terms are intended to encompass different orientations of the device in use or operation in addition to the orientation depicted in the figures. The apparatus may be otherwise oriented (rotated 90 degrees or at other orientations) and the spatially relative descriptors used herein may likewise be interpreted accordingly. When an element is referred to as being "connected," or "coupled," to another element, it can be directly connected or coupled to the other element or intervening elements may be present. Although the wide numerical ranges and parameters of the present disclosure are approximations, numerical values are set forth in the specific examples as precisely as possible. In addition, although the "first," "second, and the like terms in the claims be used to describe the various elements can be appreciated, these elements should not be limited by these terms, and these elements are described in the respective embodiments are used to express the different reference numerals, these terms are only used to distinguish one element from another element. For example, a first element could be termed a second element, and, similarly, a second element could be termed a first element, without departing from the scope of example embodiments.

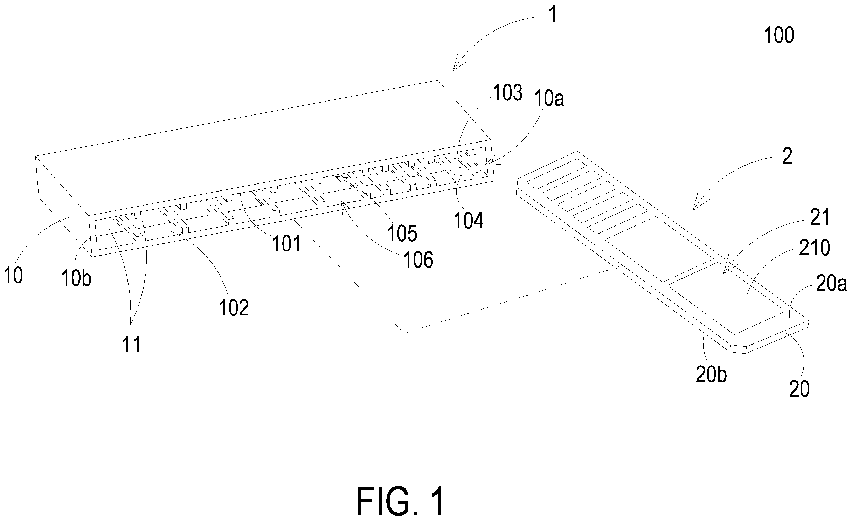

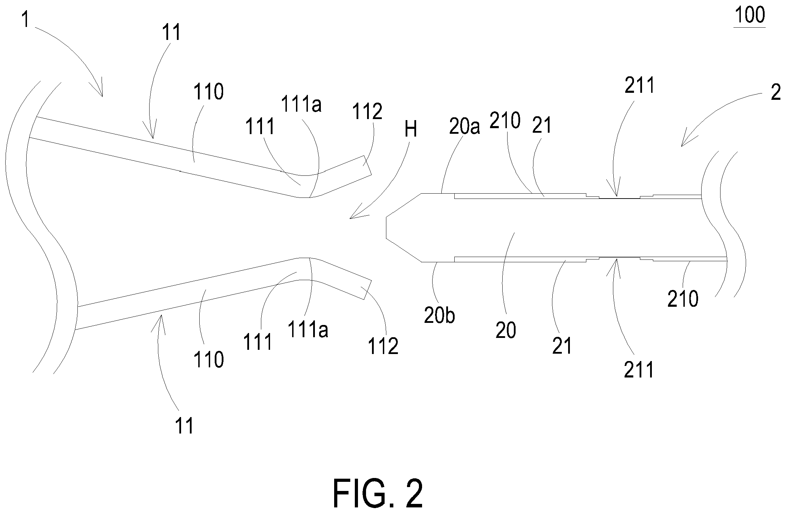

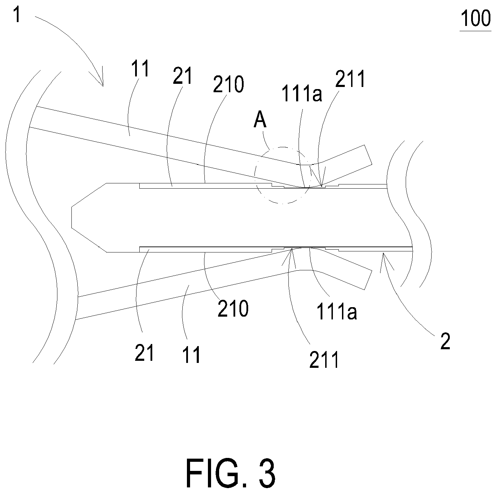

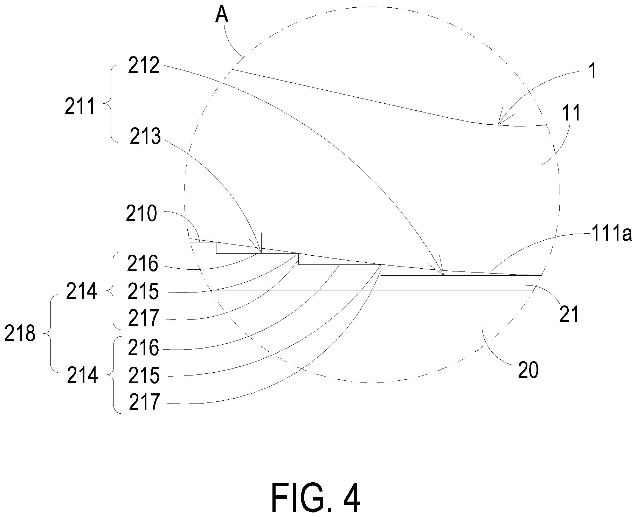

FIG. 1 is a schematic perspective view illustrating an electrical connection assembly according to a first embodiment of the present disclosure, FIG. 2 is a cross-sectional view illustrating a first electrical connector and a second electrical connector of the electrical connection assembly of FIG. 1, FIG. 3 is a cross-sectional view illustrating the second electrical connector of the electrical connection assembly of FIG. 1 in connection with the first electrical connector, and FIG. 4 is a partially enlarged cross-sectional view illustrating the electrical connection assembly in area A of FIG. 3. As shown in FIG. 1 to FIG. 4, the electrical connection assembly 100 of the first embodiment of the present disclosure includes a first electrical connector 1 and a second electrical connector 2. The first electrical connector 1 is a receptacle connector and includes at least one first terminal 11. Each first terminal 11 includes at least one contact part 111a. In the present embodiment, preferably but not exclusively, the first electrical connector 1 includes a plurality of first terminals 11, and each of the plurality of first terminals 11 includes a contact part 111a. Two first terminals 11 of the plurality of first terminals 11 are disposed corresponding to each other in position, and a gap H is defined between the two first terminals 11. The second electrical connector 2 is a gold finger connector, and configured to pluggably connect to the first electrical connector 1. The second electrical connector 2 includes at least one second terminal 21. Each second terminal 21 includes at least one recess 211. In the present embodiment, preferably but not exclusively, the second electrical connector 2 includes a plurality of second terminals 21, and each of the second terminals 21 includes a recess 211. Two second terminals 21 of the plurality of second terminals 21 are disposed on two opposite sides of the second electrical connector 2, and are disposed corresponding to each other in position. In the present embodiment, the recess 211 is inwardly recessed from a surface 210 of the second terminal 21. The recess 211 includes a bottom 212 and at least one connection section 213. The at least one connection section 213 is in connection between the bottom 212 and the surface 210 of the second terminal 21. The at least one connection section 213 includes at least one contact portion 215. In the present embodiment, preferably but not exclusively, the at least one connection section 213 includes a plurality of contact portions 215. It is noted that the number of the contact portions 215 is not limited and is adjusted according to the practical requirements. The bottom 212 and the plurality of contact portions 215 allow the contact part 111a of the first terminal 11 of the first electrical connector 1 to contact and urge against. As shown in FIG. 3 and FIG. 4, when the first electrical connector 1 and the second electrical connector 2 are in connection with and electrically coupled to each other, each of the contact parts 111a of the first terminals 11 of the first electrical connector 1 is in contact with the corresponding one of the recesses 211 of the second terminals 21 of the second electrical connector 2. Under this circumstance, the multi-points contacts are formed among each of the contact parts 111a of the first terminals 11, the bottom 212 and the plurality of contact portions 215 of corresponding one of the recesses 211 of the second terminals 21. Since the bottom 212 and the plurality of contact portions 215 of the recess 211 of the second terminal 21 of the second electrical connector 2 are in contact with the contact part 111a of the corresponding one of the first terminals 11 of the first electrical connector 1, the contact area between the first terminal 11 of the first electrical connector 1 and the second terminal 21 of the second electrical connector 2 is increased. Consequently, the contact impedance is reduced to minimize losses, the power density and efficiency are enhanced, and the temperature rise issues caused by excessive contact impedance are prevented. In addition, since the recess 211 of the second terminal 21 of the second electrical connector 2 is in contact with the contact part 111a of the corresponding one of the first terminals 11 of the first electrical connector 1, the contact area between the first electrical connector 1 and the second electrical connector 2 is increased without increasing the clamping force between the plurality of first terminals 11 of the first electrical connector 1. Consequently, the structural damage or the material fatigue due to high stress are avoided.

As shown in FIG. 1, in the present embodiment, the first electrical connector 1 includes a housing 10. The housing 10 includes an accommodation space 10a and an opening 10b. The plurality of first terminals 11 are disposed in the accommodation space 10a of the housing 10, and a free end 112 of each of the first terminals 11 is disposed adjacent to the opening 10b of the housing 10. The second electrical connector 2 includes a substrate 20. The substrate 20 has a first surface 20a and a second surface 20b opposite to each other. Two second terminals 21 of the plurality of second terminals 21 are disposed on the first surface 20a and the second surface 20b of the substrate 20, respectively, and are positionally corresponding to each other. In the present embodiment, the housing 10 has a first inner wall surface 101 and a second inner wall surface 102. The first inner wall surface 101 and the second inner wall surface 102 are positionally corresponding to each other. The housing 10 includes a plurality of first ribs 103 and a plurality of second ribs 104. The plurality of first ribs 103 are disposed on the first inner wall surface 101, and are disposed parallel to and spaced apart from each other. The plurality of second ribs 104 are disposed on the second inner wall surface 102, and are disposed parallel to and spaced apart from each other. A plurality of first areas 105 are defined between the plurality of first ribs 103, and a plurality of second areas 106 are defined between the plurality of second ribs 104. The first areas 105 and the second areas 106 are positionally corresponding to each other. Each of the first areas 105 and each of the second areas 106 are configured to accommodate the first terminal 11, respectively.

As shown in FIG. 1 to FIG. 3, in the present embodiment, the paired two first terminals 11 of the first electrical connector 1 are respectively disposed in the corresponding first area 105 and the corresponding second area 106, and are symmetrically arranged with each other. The free end 112 of each of two first terminals 11 is a flexible arm structure, respectively, and a gap H is defined between the two first terminals 11. In the present embodiment, each of the first terminals 11 includes a main section 110, a bent section 111 and a free end 112. The bent section 111 is in connection with and disposed between the main section 110 and the free end 112, and the contact part 111a is formed on the bent section 111. The bent section 111 is outwardly protruded from the first terminal 11 toward the gap H, and the contact part 111a is disposed adjacent to the gap H. Preferably but not exclusively, the contact part 111a has a curved surface. In the present embodiment, the paired two second terminals 21 of the second electrical connector 2 are disposed on the first surface 20a and the second surface 20b of the substrate 20, respectively. Two recesses 211 of the two second terminals 21 are recessed inwardly from the surface 210, respectively, and the two recesses 211 are positionally corresponding to each other. When the first electrical connector 1 is in connection with the second electrical connector 2, the substrate 20 of the second electrical connector 2 is plugged into the gap H between the two first terminals 11 of the first electrical connector 1, the contact parts 111a of the two first terminals 11 are in contact with the corresponding two second terminals 21, and the contact parts 111a of the two first terminals 11 are in contact with and urge against the corresponding recesses 211 of the two second terminals 21, respectively. Since the recesses 211 of the second terminals 21 of the second electrical connector 2 are in contact with the contact parts 111a of the corresponding first terminals 11, the contact areas between the first terminals 11 of the first electrical connector 1 and the second terminals 21 of the second electrical connector 2 are increased. Consequently, the contact impedance is reduced to minimize losses, the power density and efficiency are enhanced, the temperature rise issues caused by excessive contact impedance are prevented, and the structural damage or the material fatigue due to high stress are avoided.

In the present embodiment, the profiles of the two recesses 211 of the two second terminals 21 of the second electrical connector 2 are in match with the profiles of the contact parts 111a of the two first terminals 11 of the first electrical connector 1, so that multi-points contacts are formed between the contact parts 111a of the first terminals 11 of the first electrical connector 1 and the plurality of contact portions 215 of the recesses 211 of the second terminals 21 of the second electrical connector 2. Consequently, the contact area is increased, and the contact impedance is reduced to minimize losses.

In some embodiments, the recess 211 of the second terminal 21 of the second electrical connector 2 is formed on the surface 210 of the second terminal 21 by processes such as metal layer etching, metal layer stacking, metal layer electroplating, metal layers on printed circuit multilayer boards, or mechanical processing of metal layers, but not limited thereto.

As shown in FIG. 1 to FIG. 4, in the present embodiment, the bottom 212 and the at least one connection section 213 of the recess 211 collectively form a discontinuous arc profile structure. The at least one connection section 213 of the recess 211 includes at least one step structure 218. The step structure 218 is in connection between the surface 210 of the second terminal 21 and the bottom 212 of the recess 211. The plurality of contact portions 215 are formed on the at least one step structure 218. When the first electrical connector 1 and the second electrical connector 2 are in connection with and electrically coupled to each other, the contact part 111a of the first terminal 11 of the first electrical connector 1 is in contact with and urges against the bottom 212 and the contact portions 215 of the step structure 218 of the recess 211. By the arrangement of the step structure 218 and the bottom 212, the contact areas between the first terminal 11 of the first electrical connector 1 and the second terminal 21 of the second electrical connector 2 are increased. Consequently, the contact impedance is reduced to minimize losses, the power density and efficiency are enhanced, the temperature rise issues caused by excessive contact impedance are prevented, and the structural damage or the material fatigue due to high stress are avoided. Each of the contact portions 215 of the second terminal 21 depicted in FIG. 4 is shown to make a single-point contact with the contact part 111a of the first terminal 11. It is noted that the contact method is not limited to the above embodiment and is adjusted according to the practical requirements. For example, when the contact part 111a of the first terminal 11 is in contact with each of the contact portions 215 of the second terminal 21, the contact portions 215 of the second terminal 21 are subjected to deformation in response to the force applied by the contact part 111a of the first terminal 11. In other words, the contact part 111a is in contact with the contact portions 215 in a surface contact manner, but not limited thereto.

In an embodiment, an end of the bottom 212 is in connection with the surface 210 of the second terminal 21 by one step structure 218, and another end of the bottom 212 is in connection with the surface 210 of the second terminal 21 by another step structure 218, but not limited thereto. By the arrangement of the two step structures 218 and the bottom 212, the contact area between the first terminal 11 of the first electrical connector 1 and the second terminal 21 of the second electrical connector 2 is increased. Consequently, the contact impedance is reduced to minimize losses, the power density and efficiency are enhanced, the temperature rise issues caused by excessive contact impedance are prevented, and the structural damage or the material fatigue due to high stress are avoided.

Alternatively, in other embodiment, the step structure 218 surrounds the bottom 212, and is in connection between the surface 210 and the bottom 212. In other words, the step structure 218 is a ring-shaped structure (not shown). Consequently, the contact area between the first terminal 11 of the first electrical connector 1 and the second terminal 21 of the second electrical connector 2 is increased, the contact impedance is reduced to minimize losses, the power density and efficiency are enhanced, the temperature rise issues caused by excessive contact impedance are prevented, and the structural damage or the material fatigue due to high stress are avoided.

In the present embodiment, the contact part 111a of the first terminal 11 and the plurality of contact portions 215 of the step structure 218 of the second terminal 21 are in contact with each other, so that the multi-points contact is formed between the contact part 111a and the step structure 218. Consequently, the contact area between the first terminal 11 and the second terminal 21 is increased, and the contact impedance is reduced to minimize losses.

As shown in FIG. 4, the step structure 218 includes at least one step 214. In the present embodiment, preferably but not exclusively, the step structure 218 includes a plurality of steps 214. In the present embodiment, each of the steps 214 of the step structure 218 has a top surface 216 and a connection surface 217. An end of the connection surface 217 is in connection with the top surface 216 or the surface 210, and another end of the connection surface 217 is in connection with the top surface 216 of one adjacent step 214 or the bottom 212. Each contact portion 215 is formed at the junction of the top surface 216 and the connection surface 217 of the step 214. By the arrangement of the contact portion 215 of the step structure 218, the contact area between the first terminal 11 of the first electrical connector 1 and the second terminal 21 of the second electrical connector 2 is increased. Consequently, the contact impedance is reduced to minimize losses, the power density and efficiency are enhanced, the temperature rise issues caused by excessive contact impedance are prevented, and the structural damage or the material fatigue due to high stress are avoided. Additionally, the structure of the plurality of steps 214 of the step structure 218 is simple, which is easy to manufacture and has lower cost.

In some embodiments, the bottom 212 and at least one connection section 213 of the recess 211 collectively form a continuous arc profile structure. In other words, the recess 211 is a continuous arc profile structure recessed inwardly from the surface 210 of the second terminal 21. The continuous arc profile structure of the recess 211 of the second terminal 21 is in match with the curved surface of the contact part 111a of the first terminal 11, so that the contact area between the first terminal 11 of the first electrical connector 1 and the second terminal 21 of the second electrical connector 2 is increased. Consequently, the contact impedance is reduced to minimize losses, the power density and efficiency are enhanced, the temperature rise issues caused by excessive contact impedance are prevented, and the structural damage or the material fatigue due to high stress are avoided.

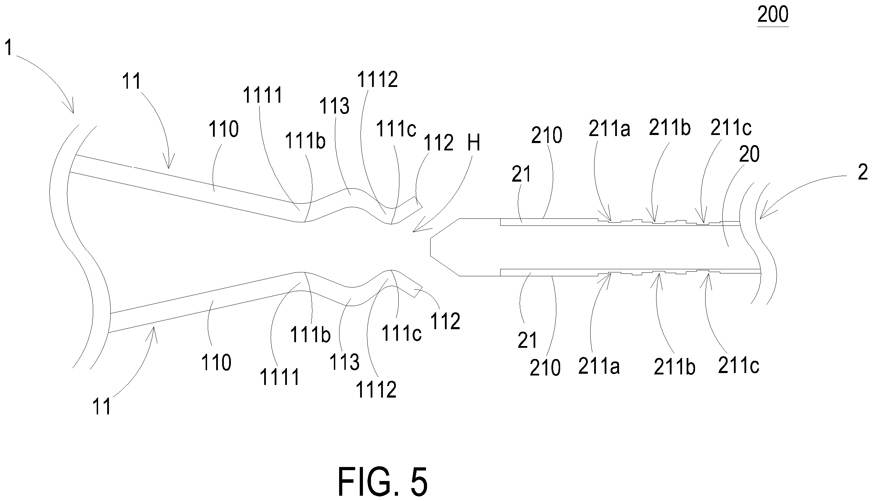

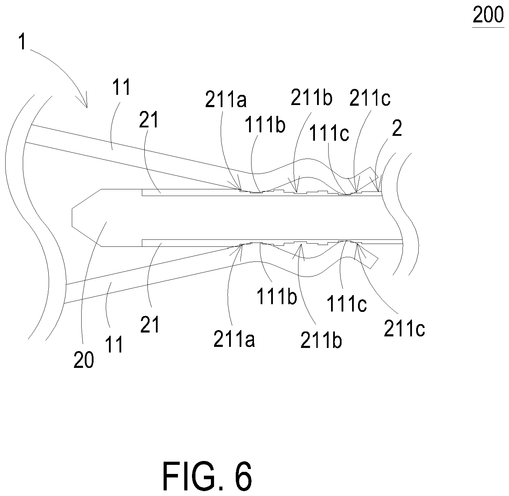

FIG. 5 is a cross-sectional view illustrating a first electrical connector and a second electrical connector of an electrical connection assembly according to a second embodiment of the present disclosure, and FIG. 6 is a cross-sectional view illustrating the second electrical connector of the electrical connection assembly of FIG. 5 in connection with the first electrical connector. As shown in FIG. 5 and FIG. 6, the electrical connection assembly 200 of the second embodiment of the present disclosure is similar to the electrical connection assembly 100 of the first embodiment shown in FIG. 1 to FIG. 4, wherein the same references represent the same components and functions, and would not be repeatedly described hereinafter. Different from the electrical connection assembly 100 of the first embodiment shown in FIG. 1 to FIG. 4, each of the first terminals 11 of the first electrical connector 1 of the electrical connection assembly 200 of the present embodiment includes a main section 110, a first bent section 1111, a third bent section 113, a second bent section 1112 and a free end 112, and each of the second terminals 21 of the second electrical connector 2 includes a first recess 211a, a second recess 211b and a third recess 211c. The main section 110, the first bent section 1111, the third bent section 113, the second bent section 1112 and the free end 112 are connected in sequence. The first bent section 1111 and the second bent section 1112 are outwardly protruded from the first terminal 11 toward the gap H, and are disposed apart from each other. The first terminal 11 has a first contact part 111b and a second contact part 11 1c. The first contact part 111b is formed on the first bent section 1111 and disposed adjacent to the gap H. The second contact part 111c is formed on the second bent section 1112 and disposed adjacent to the gap H. The first recess 211a, the second recess 211b and the third recess 211c of the second terminal 21 are arranged in sequence and spaced apart from each other on the surface 210 of the second terminal 21. As shown in FIG. 6, when the first electrical connector 1 is in connection with and electrically coupled to the second electrical connector 2, the first contact part 111b and the second contact part 111c of each of the first terminals 11 of the first electrical connector 1 are in contact with and urge against two of the first recess 211a, the second recess 211b and the third recess 211c of corresponding second terminal 21 of the second electrical connector 2, respectively. For example, the first contact part 111b is in contact with and urges against the first recess 211a, and the second contact part 111c is in contact with and urges against the third recess 211c. Consequently, the contact area between the first terminal 11 of the first electrical connector 1 and the second terminal 21 of the second electrical connector 2 is increased. Consequently, the contact impedance is reduced to minimize losses, the power density and efficiency are enhanced, the temperature rise issues caused by excessive contact impedance are prevented, and the structural damage or the material fatigue due to high stress are avoided. It is emphasized that the amount and the positions of the contact part 111a, 111b, 111c of the first terminal 11 of the first electrical connector 1 and the recess 211, 211a, 211b, 211c of the second terminal 21 of the second electrical connector 2 are not limited to the above-mentioned embodiments, and can be modified according to practical requirements.

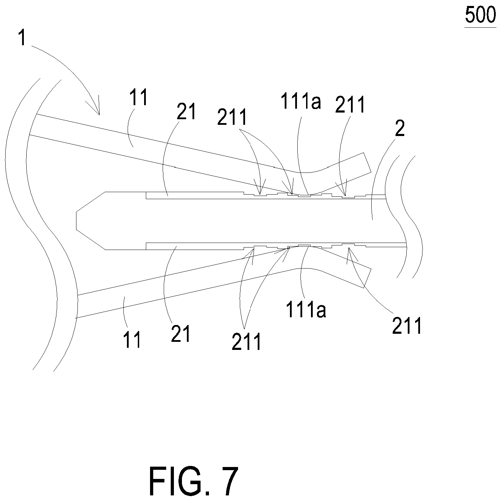

FIG. 7 is a cross-sectional view illustrating a first electrical connector and a second electrical connector of an electrical connection assembly according to a third embodiment of the present disclosure. As shown in FIG. 7, the second electrical connector 2 of the electrical connection assembly 500 of the third embodiment of the present disclosure is similar to the second electrical connector 2 of the second embodiment shown in FIG. 5 and FIG. 6, and the first electrical connector 1 of the electrical connection assembly 500 of the present embodiment is similar to the first electrical connector 1 of the first embodiment shown in FIG. 1 to FIG. 4, wherein the same references represent the same components and functions, and would not be repeatedly described hereinafter. In the present embodiment, the second terminals 21 of the second electrical connector 2 of the electrical connection assembly 500 are applicable to different types of the first terminals of the first electrical connectors 1. As shown in FIG. 7, each of the first terminals 11 of the first electrical connector 1 of the electrical connection assembly 500 includes single contact part 111a, and each of the second terminals 21 of the second electrical connector 2 includes three recesses 211. When the first electrical connector 1 is in connection with and electrically coupled to the second electrical connector 2, the contact part 111a of the first terminal 11 of the first electrical connector 1 is in contact with and urges against any one of the three recesses 211 of the second terminal 21 of the second electrical connector 2. For example, the contact part 111a shown in FIG. 7 is in contact with and urges against the middle one of the three recesses 211, but not limited thereto. Alternatively, in other embodiment, each of the first terminals 11 of the first electrical connector 1 includes three contact parts 111a (not shown), and each of the second terminals 21 of the second electrical connector 2 includes three recesses 211 (e.g., the second terminal 21 of the second electrical connector 2 shown in FIG. 5). When the first electrical connector 1 is in connection with and electrically coupled to the second electrical connector 2, the three contact parts 111a of the first terminal 11 of the first electrical connector 1 are in contact with and urge against the three recesses 211 of the corresponding second terminal 21 of the second electrical connector 2, respectively. In above-mentioned embodiment, since each of the second terminals 21 of the second electrical connector 2 includes a plurality of recesses 211, the second electrical connector 2 are applicable to different types of the first electrical connectors 1. Consequently, high flexibility of the assembly application between the first electrical connector 1 and the second electrical connector 2 is performed, and the advantages of increasing the contact area between the first terminal 11 and the second terminal 22, reducing contact impedance and avoiding structural damage or material fatigue caused by high stress are achieved.

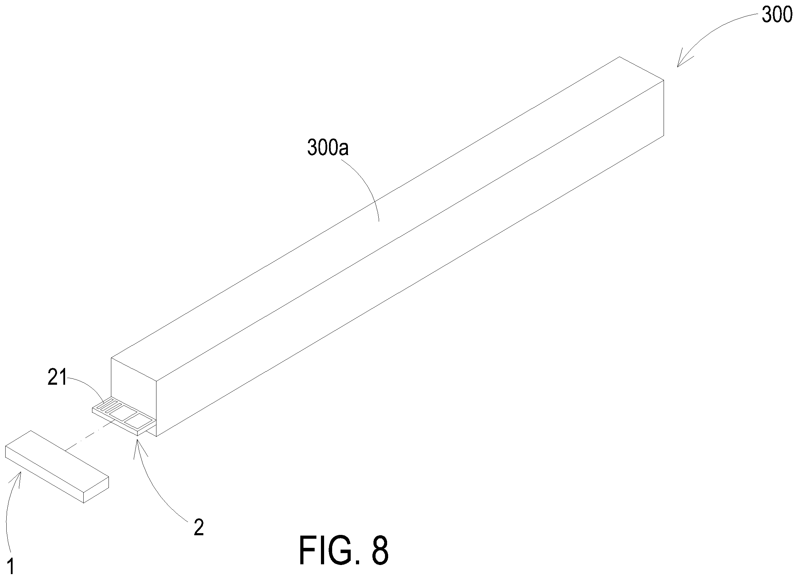

FIG. 8 is a schematic perspective view illustrating the electrical connection assembly applied to a power supply system. As shown in FIG. 8, the electrical connection assembly 100, 200 is applicable to a power supply system 300. The power supply system 300 includes a power supply unit 300a (PSU). The power supply unit 300a includes a circuit assembly (not shown) disposed therein. The second electrical connector 2 of the electrical connection assembly 100, 200 is disposed on the rear side of the power supply unit 300a and is electrically connected to the circuit assembly. The first electrical connector 1 for example but not limited to be disposed inside a rack (not shown). In an embodiment, the power supply unit 300a is hot swapped to the rack (not shown), and the second electrical connector 2 of the power supply unit 300a is pluggably in connection with the first electrical connector 1 of the rack. In this embodiment, the structures and functions of the first electrical connector 1 and the second electrical connector 2 are similar to that of the first electrical connector 1 and the second electrical connector 2 of the above-mentioned embodiments, and would not be redundantly described hereinafter.

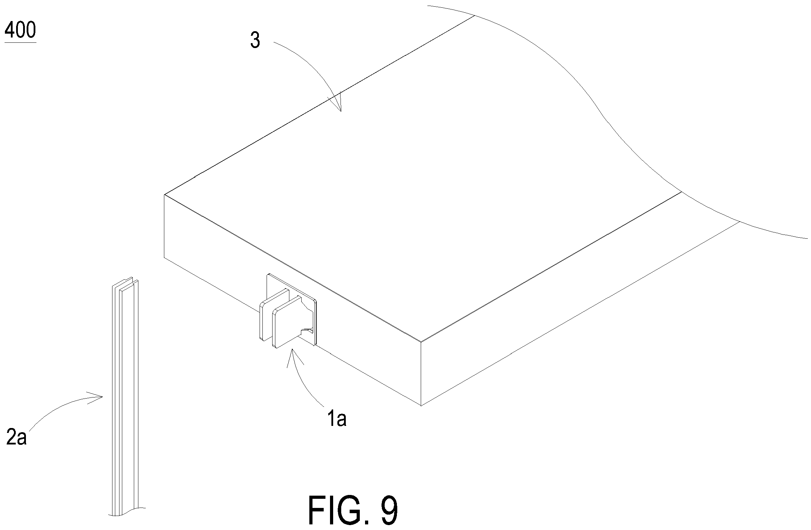

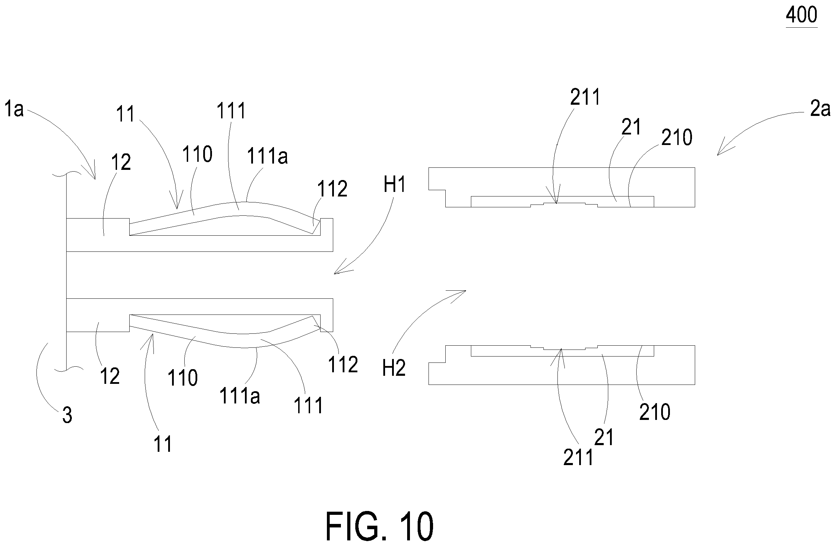

FIG. 9 is a schematic perspective view illustrating an electrical connection assembly according to a fourth embodiment of the present disclosure, and FIG. 10 is a partial cross-sectional view illustrating a first electrical connector and a second electrical connector of the electrical connection assembly of FIG. 9. As shown in FIG. 9 and FIG. 10, the electrical connection assembly 400 of the fourth embodiment of the present disclosure includes a first electrical connector 1a and a second electrical connector 2a. In the present embodiment, the first electrical connector 1a is a bus bar connector, and the first electrical connector 1a is disposed on a rear side of a power shelf 3. The first electrical connector 1a is configured to output DC power from the power shaft 3. The second electrical connector 2a is a system bus bar assembly. The system bus bar assembly is disposed in a rack (not shown) for connecting with the bus bar connector (such as the first electrical connector 1a) of the power shelf 3, so as to receive and convey the DC power outputted from the power shelf 3. The first electrical connector 1a includes two plates 12 and at least one first terminal 11. The two plates 12 are parallel to and spaced apart from each other and define a first gap H1 therebetween. In the present embodiment, preferably but not exclusively, the first electrical connector 1a includes a plurality of first terminals 11, and two first terminals 11 of the plurality of first terminals 11 are disposed on the side surfaces of the two plates 12, and are positionally corresponding to each other and face toward opposite directions. Each of the first terminals 11 includes at least one contact part 111a. In the present embodiment, each of the first terminals 11 includes a main section 110, a bent section 111 and a free end 112. The bent section 111 is disposed and in connection between the main section 110 and the free end 112, and the bent section 111 is outwardly protruded from the first terminal 11 toward a direction away from the plate 12. The contact part 111a is disposed on the bent section 111, and is disposed toward the direction away from the plate 12. The structure and function of the contact part 111a of the first terminal 11 of the first electrical connector 1a are similar to that of the contact part 111a of the first terminal 11 of the first electrical connector 1 of the first embodiment or the second embodiment, and would not be redundantly described hereinafter.

In the present embodiment, preferably but not exclusively, the second electrical connector 2a includes two second terminals 21, and each of the second terminals 21 is a bus bar. The two paired bus bars (i.e., the second terminals 21) are parallel to and spaced apart from each other and define a second gap H2 therebetween. The two bus bars (i.e., the second terminals 21) are a positive bus copper bar and a negative bus copper bar, respectively, so as to form the above-mentioned system bus bar assembly. Each of the second terminals 21 (i.e., each of the bus bars) includes at least one recess 211. Each of the recesses 211 is inwardly recessed from the surface 210 of the second terminal 21, and each of the recesses 211 is disposed adjacent to the second gap H2. In this embodiment, the structure and function of the recess 211 of the second terminal 21 of the second electrical connector 2a are similar to that of the recess 211 of the second terminal 21 of the second electrical connector 2 of the second electrical connector 2 of the first embodiment or the second embodiment, and would not be redundantly described hereinafter.

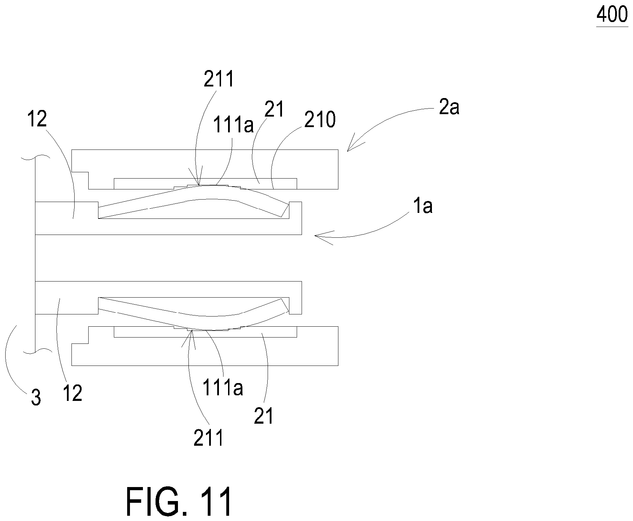

FIG. 11 is a cross-sectional view illustrating the second electrical connector of the electrical connection assembly of FIG. 10 in connection with the first electrical connector. As shown in FIG. 10 and FIG. 11, when the first electrical connector 1a is in connection with and electrically coupled to the second electrical connector 2a, the contact parts 111a of the two first terminals 11 of the first electrical connector 1a are in contact with and urge against the corresponding recesses 211 of the two second terminals 21 of the second electrical connector 2a, respectively. The connection method of the contact part 111a of the first terminal 11 of the first electrical connector 1a and the recess 211 of the second terminal 21 of the second electrical connector 2a is similar to the connection method of the first embodiment or the second embodiment, and would not be redundantly described hereinafter. Since the contact part 111a of the first terminal 11 of the first electrical connector 1a is in contact with the recess 211 of the corresponding second terminal 21 of the second electrical connector 2a, high flexibility of the assembly application between the first electrical connector 1a and the second electrical connector 2a is performed, and the advantages of increasing the contact area between the terminals, reducing contact impedance and avoiding structural damage or material fatigue caused by high stress are achieved.

From above descriptions, the present disclosure provides an electrical connection assembly. The electrical connection assembly includes a first electrical connector and a second electrical connector. The bottom and the contact portions of the recess of the second terminal of the second electrical connector are in contact with the contact part of the corresponding first terminal of the first electrical connector, so that the contact area between the first terminal of the first electrical connector and the second terminal of the second electrical connector is increased. Consequently, the contact impedance is reduced to minimize losses, the power density and efficiency are enhanced, the temperature rise issues caused by excessive contact impedance are prevented, and the structural damage or the material fatigue due to high stress are avoided.

## Claims

1. An electrical connection assembly (100, 200, 400, 500), **characterized by** comprising:
a first electrical connector (1, 1a) comprising at least one first terminal (11), wherein each of the at least one first terminal (11) comprises at least one contact part (111a); and
a second electrical connector (2, 2a) configured to pluggably connect with the first electrical connector (1, 1a), and comprising at least one second terminal (21), wherein each of the at least one second terminal (21) comprises at least one recess (211), the at least one recess (211) is inwardly recessed from a surface (210) of the second terminal (21), wherein each of the at least one recess (211) comprises at least one connection section (213) and a bottom (212), the at least one connection section (213) is in connection between the bottom (212) and the surface (210) of the second terminal (21), wherein the at least one connection section (213) comprises a plurality of contact portions (215),
wherein the at least one contact part (111a) of each of the at least one first terminal (11) of the first electrical connector (1, 1a) is in connection with and urges against the at least one recess (211) of the corresponding second terminal (21) of the second electrical connector (2, 2a), and the at least one contact part (111a) of the at least one first terminal (11) is in contact with and urges against the bottom (212) and the plurality of contact portions (215) of the at least one recess (211) of the at least one second terminal (21) to form a multi-points contact.

2. The electrical connection assembly according to claim 1, wherein the first electrical connector (1, 1a) is a receptacle connector, and the second electrical connector (2, 2a) is a gold finger connector, wherein the at least one first terminal (11) comprises a plurality of first terminals (11), two first terminals (11) of the plurality of first terminals (11) are corresponding to each other in position, and a gap (H) is defined between the two first terminals (11), wherein the at least one second terminal (21) comprises a plurality of second terminals (21), two second terminals (21) of the plurality of second terminals (21) are disposed on two opposite sides of the second electrical connector (2, 2a), and are corresponding to each other in position, wherein when the first electrical connector (1, 1a) and the second electrical connector (2, 2a) are in connection with and electrically coupled to each other, the contact parts (111a) of the two first terminals (11) of the first electrical connector (1, 1a) are in contact with and urge against the recesses (211) of the corresponding two second terminals (21) of the second electrical connector (2, 2a), respectively.

3. The electrical connection assembly according to claim 2, wherein the first electrical connector (1, 1a) comprises a housing (10), the housing (10) comprises an accommodation space (10a) and an opening (10b), wherein the plurality of first terminals (11) are disposed in the accommodation space (10a) of the housing (10), wherein the second electrical connector (2, 2a) comprises a substrate (20), the substrate (20) has a first surface (20a) and a second surface (20b) opposite to each other, wherein two second terminals (21) of the plurality of second terminals (21) are disposed on the first surface (20a) and the second surface (20b) of the substrate (20), respectively, and are corresponding to each other in position.

4. The electrical connection assembly according to claim 3, wherein the plurality of first terminals (11) arm flexible are structures, respectively, wherein each of the plurality of first terminals (11) includes a main section (110), a bent section (111) and a free end (112), wherein the bent section (111) is in connection and disposed between the main section (110) and the free end (112), and the contact part (111a) is formed on the bent section (111), wherein the bent section (111) is outwardly protruded from the first terminal (11) toward the gap (H), and the contact part (111a) is disposed adjacent to the gap (H), wherein the paired two second terminals (21) of the second electrical connector (2, 2a) are disposed on the first surface (20a) and the second surface (20b) of the substrate (20), respectively, each of the plurality of second terminals (21) comprises one recess (211), and the recess (211) is recessed inwardly from the surface (210) of the second terminal (21), respectively, wherein the recesses (211) of the two second terminals (21) are corresponding to each other in position, wherein when the first electrical connector (1, 1a) is in connection with and electrically coupled to the second electrical connector (2, 2a), the substrate (20) of the second electrical connector (2, 2a) is plugged into the gap (H) between the two first terminals (11) of the first electrical connector (1, 1a), the contact parts (111a) of the two first terminals (11) are in contact with and urge against the recesses (211) of the two second terminals (21), respectively.

5. The electrical connection assembly according to claim 3, wherein the housing (10) has a first inner wall surface (101), a second inner wall surface (102), a plurality of first ribs (103) and a plurality of second ribs (104), wherein the first inner wall surface (101) and the second inner wall surface (102) are corresponding to each other, wherein the plurality of first ribs (103) are disposed on the first inner wall surface (101), and are disposed parallel to and spaced apart from each other, wherein the plurality of second ribs (104) are disposed on the second inner wall surface (102), and are disposed parallel to and spaced apart from each other, wherein a plurality of first areas (105) are defined between the plurality of first ribs (103), and a plurality of second areas (106) are defined between the plurality of second ribs (104), wherein the first areas (105) and the second areas (106) are corresponding to each other in position, wherein the paired two first terminals (11) of the first electrical connector (1, 1a) are respectively disposed in the corresponding first area (105) and the corresponding second area (106), and are symmetrically arranged with each other.

6. The electrical connection assembly according to claim 1, wherein the bottom (212) and the at least one connection section (213) of the recess (211) collectively form a discontinuous arc profile structure or a continuous arc profile structure, wherein the contact part (111a) is a curved surface.

7. The electrical connection assembly according to claim 1, wherein the at least one recess (211) is formed on the surface (210) of the second terminal (21) by metal layer etching, metal layer stacking, metal layer electroplating, metal layers on printed circuit multilayer boards, or mechanical processing of metal layers.

8. The electrical connection assembly according to claim 1, wherein the at least one connection section (213) comprises at least one step structure (218), and the plurality of contact portions (215) of the at least one second terminal (21) are formed on the at least one step structure (218).

9. The electrical connection assembly according to claim 8, wherein the step structure (218) comprises a plurality of steps (214), wherein each of the steps (214) has a top surface (216) and a connection surface (217), wherein an end of the connection surface (217) is in connection with the top surface (216) or the surface (210) of the second terminal (21), and another end of the connection surface (217) is in connection with the top surface (216) of adjacent step or the bottom (212), wherein each of the contact portions (215) is formed at the junction of the top surface (216) and the connection surface (217) of each of the steps (214).

10. The electrical connection assembly according to claim 1, wherein each of the second terminals (21) of the second electrical connector (2, 2a) comprises a first recess (211a), a second recess (211b) and a third recess (211c), wherein the first recess (211a), the second recess (211b) and the third recess (211c) of the second terminal (21) are arranged in sequence and spaced apart from each other on the surface (210) of the second terminal (21), wherein when the first electrical connector (1, 1a) is in connection with and electrically coupled to the second electrical connector (2, 2a), the at least one contact part (111a) of each of the first terminals (11) of the first electrical connector (1, 1a) is in contact with one or combination of the first recess (211a), the second recess (211b) and the third recess (211c) of the corresponding second terminal (21) of the second electrical connector (2, 2a), respectively.

11. The electrical connection assembly according to claim 10, wherein the at least one first terminal (11) comprises a plurality of first terminals (11), a gap (H) is defined between the paired two first terminals (11), each of the plurality of first terminals (11) of the first electrical connector (1, 1a) comprises a main section (110), a first bent section (1111), a third bent section (113), a second bent section (1112) and a free end (112), which are connected in sequence, wherein the first bent section (1111) and the second bent section (1112) are outwardly protruded from the first terminal (11) toward the gap (H), and are spaced apart from each other, wherein the first terminal (11) has a first contact part and a second contact part (11 1c), wherein the first contact part (111b) is formed on the first bent section (1111), and disposed adjacent to the gap (H), wherein the second contact part (111c) is formed on the second bent section (1112), and disposed adjacent to the gap (H), wherein when the first electrical connector (1, 1a) is in connection with and electrically coupled to the second electrical connector (2, 2a), the first contact part (111b) and the second contact part (111c) of each of the first terminals (11) of the first electrical connector (1, 1a) are in contact with two of the first recess (21 1a), the second recess (211b) and the third recess (211c) of corresponding second terminal (21) of the second electrical connector (2, 2a), respectively.

12. The electrical connection assembly according to claim 1, wherein the second electrical connector (2, 2a) is disposed on a rear side of a power supply unit (300a).

13. The electrical connection assembly according to claim 1, wherein the first electrical connector (1a) is a bus bar connector, and the first electrical connector (1a) is disposed on a rear side of a power shelf (3), wherein the second electrical connector (2a) is a system bus bar assembly for connecting with the bus bar connector of the power shelf (3), wherein the first electrical connector (1a) comprises two plates (12) and at least one first terminal (11), the two plates (12) are parallel to and spaced apart from each other and define a first gap (H1) therebetween, wherein each of the at least one first terminal (11) comprises a main section (110), a bent section (111) and a free end (112), the bent section (111) is disposed and in connection between the main section (110) and the free end (112), and the bent section (111) is outwardly protruded toward a direction away from the plate (12), wherein the contact part (111a) is disposed on the bent section (111), and is disposed toward the direction away from the plate (12), wherein the at least one second electrical connector (2a) comprises two second terminals (21), and each of the second terminals (21) is a bus bar, two paired bus bars are parallel to and spaced apart from each other and define a second gap (H2) therebetween, wherein the at least one recess (211) of each of the plurality of second terminals (21) is disposed adjacent to the second gap (H2).
